(19) Europäisches Patentamt
European Patent Office
Office européen des brevets

(11) **EP 4 478 069 A1**

(12) **EUROPEAN PATENT APPLICATION**
published in accordance with Art. 153(4) EPC

(43) Date of publication:
**18.12.2024 Bulletin 2024/51**

(21) Application number: **22926199.5**

(22) Date of filing: **02.12.2022**

(51) International Patent Classification (IPC):
*G01R 31/392* (2019.01)   *G01R 19/165* (2006.01)
*G01R 31/3842* (2019.01)   *G01R 31/396* (2019.01)
*G01R 19/00* (2006.01)   *G01R 19/10* (2006.01)

(52) Cooperative Patent Classification (CPC):
**G01R 19/00; G01R 19/10; G01R 19/165;
G01R 31/3842; G01R 31/392; G01R 31/396;
Y02E 60/10**

(86) International application number:
**PCT/KR2022/019484**

(87) International publication number:
**WO 2023/153602 (17.08.2023 Gazette 2023/33)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.02.2022 KR 20220015884**

(71) Applicant: **Mintech Co., Ltd.
Daejeon 34026 (KR)**

(72) Inventors:
• **HONG, Young Jin
Daejeon 34010 (KR)**
• **JEONG, Ji Hyeon
Daejeon 35273 (KR)**
• **LEE, Young Jae
Daejeon 34010 (KR)**
• **CHOI, Sung Ho
Daejeon 34008 (KR)**
• **MYOUNG, Seok Han
Seoul 07638 (KR)**
• **JU, Yu Jin
Daejeon 34008 (KR)**
• **KIM, Du Ri
Daejeon 34007 (KR)**

(74) Representative: **Gille Hrabal
Partnerschaftsgesellschaft mbB
Patentanwälte
Brucknerstraße 20
40593 Düsseldorf (DE)**

(54) **APPARATUS AND METHOD FOR ESTIMATING BATTERY STATE OF HEALTH**

(57) The present invention relates to an apparatus and method capable of estimating a battery state of health, and more particularly, provides an apparatus and method for more accurately calculating the state of balance by voltage of a battery to reflect SOC information as well as the voltage distribution of the battery, and measuring the state of health of the battery on the basis of the state of balance by voltage.

EP 4 478 069 A1

FIG.3

DERIVE VARIOUS PARAMETER VALUES INCLUDING BATTERY USAGE VOLTAGE RANGE Vf

DETERMIN VOLTAGE DIFFERENCE ALLOWABLE LIMT dV AND ALLOWABLE LIMIT QUANTILE X OF BATTERY CELLS

CALCULATE QUANTILE DROP RATE Y AND REFERENCE DEVIATION VOLTAGE dV/X BASED ON ALLOWABLE LIMIT QUANTILE X

CALCULATE AVERAGE VOLTAGE $V_{avg}$ AND STANDARD DEVIATION $\sigma n$ BASED ON MEASURED VOLTAGE $V_{cell}$ FOR EACH BATTERY CELL

DERIVE INITIAL QUANTILE ORDER N INCLUDING MEASURED VOLTAGES OF ALL CELLS WITHIN ALLOWABLE LIMIT QUANTILE X

CALCULATE PRIMARY STATE-OF-BALANCE VALUE BY VOLTAGE $SOB1_{voltage}$ BASED ON INITIAL QUANTILE ORDER N AND QUANTILE DROP RATE Y

CALCULATE CORRECTION FACTOR A BASED ON INITIAL QUANTILE ORDER N, REFERENCE DEVIATION VOLTAGE dV/X, AND STANDARD DEVIATION $\sigma n$

CALCULATE V-dQ/dV GRAPH FROM BATTERY Q-V GRAPH, AND CALCULATE dQ/dV VALUES OF REFERENCE POINT AND MEASUREMENT POINT

CALCULATE SECONDARY STATE-OF-BALANCE VALUE BY VOLTAGE $SOB2_{voltage}$ BASED ON PRIMARY STATE-OF-BALANCE VALUE BY VOLTAGE $SOB1_{voltage}$, CORRECTION FACTOR A, AND QUANTILE DROP RATE Y, AND CALCULATE $SOB3_{voltage}$ USING dQ/dV VALUES

ESTIMATE STATE-OF-HEALTH BALANCE $SOH_{balance}$ BY APPLYING SECONDARY STATE-OF-BALANCE VALUE BY VOLTAGE $SOB2_{voltage}$ TO STATE OF HEALTH OF BATTERY $SOH_{capacity}$ ACCORDING TO REFERENCE CAPACITY

**Description**

## TECHNICAL FIELD

The present invention relates to an apparatus and method capable of estimating a state of health of a battery, and more particularly, to a method for more accurately calculating a state-of-balance value by voltage by reflecting state-of-charge (SOC) information about a battery and measuring a state of health of a battery based on the state-of-balance value of the battery by voltage.

## BACKGROUND ART

A battery module or battery pack is a device manufactured by combining a plurality of battery cells to protect against physical shock from the external environment and perform a specific role, and is generally simply referred to as a "battery." For example, representative batteries are rechargeable batteries installed in smartphones, walkie-talkies, laptops, and the like, and in the case of high power consumption such as electric bicycles and electric vehicles, a single battery pack structure may be designed by bundling together as few as one or two to as many as dozens of batteries.

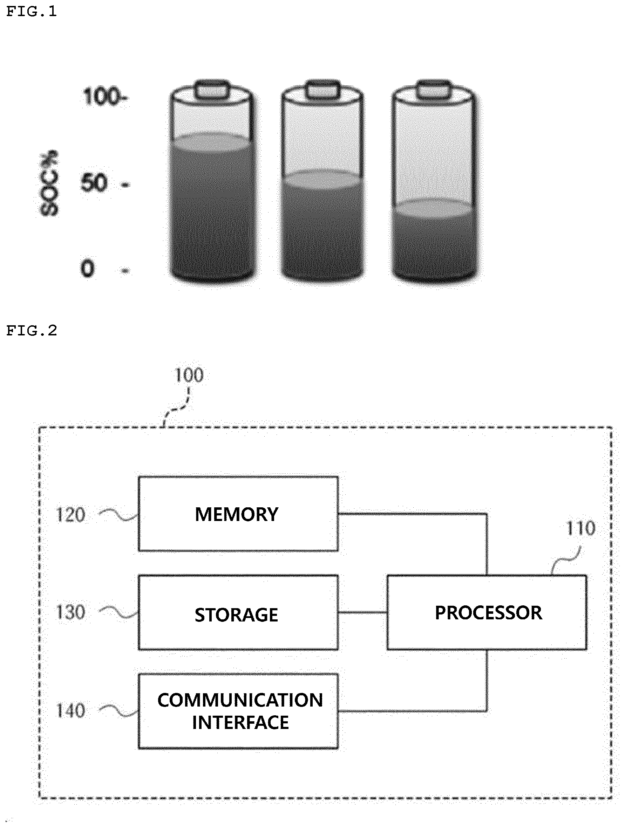

Meanwhile, when the lifespan of a battery decreases and the battery operates in the form of a battery pack, overcharging or overdischarging of some cells occurs when the degree of voltage deviation of cells constituting the battery pack increases (FIG. 1). As described above, when overcharged or overdischarged cells occur among the cells of the battery, safety is greatly reduced, which may result in a risk of leading to fire or explosion in abnormal situations. In addition, when some of the battery cells first reach an upper limit voltage or lower limit voltage, the use of the battery is limited even though there is remaining capacity, and thus there is a limitation that the entire capacity of the battery is not able to be used.

Therefore, a method has been devised to calculate a state of balance (SOB) by voltage based on the voltage distribution of the plurality of cells constituting the battery pack and calculate a state of health (SOH) based on the calculated SOB, but there is a problem in that the voltage deviation according to a state of charge (SOC) of the cells is not reflected, and thus, even though the SOB is the same, the SOB is distorted and differently calculated depending on the SOC.

[Citation List]

[Patent Document]

    1. Korean Patent Laid-Open Publication No. 10-2016-0058281

    2. Korean Patent Registration No. 10-2256117.

## DISCLOSURE OF THE INVENTION

## TECHNICAL PROBLEM

In order to solve a first problem, the present invention provides an apparatus capable of calculating a state of balance (SOB) by voltage of cells constituting a battery pack and accurately estimating a state of health of a battery by applying the SOB calculated as above, and a method thereof.

In order to solve a second problem, the present invention provides an apparatus capable of more accurately estimating a state of health of a battery by calculating a state of balance (SOB) by voltage by reflecting SOC information about cells constituting a battery pack when calculating the SOB of the cells, and a method thereof.

Objects of the present invention are not limited to those mentioned above, and other objects of the present invention that are not mentioned above could be understood by the detailed description and be more clearly understood from embodiments set forth in the present invention. Further, it will be readily understood that objects and advantages of the present invention may be implemented by means set forth in the claims and combinations thereof.

## TECHNICAL SOLUTION

In order to achieve the objects described above, according to one aspect of the present invention, an apparatus for estimating a state of health of a battery includes a memory configured to load a program for calculating a state-of-balance value by voltage of a plurality of cells constituting a battery and estimating a state-of-health balance value that is a state-of-health value of the battery to which the state-of-balance value by voltage is applied and a processor configured to execute instructions included in the program loaded by the memory.

In this case, the processor may be configured to, according to execution of the program, set a voltage difference allowable limit value within a voltage difference between a fully charged state voltage of the battery and a discharged state voltage thereof and set an allowable limit quantile that subdivides an allowable limit range to which the voltage difference allowable limit value is applied into one or more analysis sections based on an average voltage value derived from measured voltage values of the cells, calculate a voltage drop rate in the allowable limit range based on the average voltage value, where a quantile drop rate based on the allowable limit quantile is calculated as the voltage drop rate, derive a quantile order that is an order of an analysis section in which all measured voltage values for each cell are initially included within the allowable limit quantile, calculate the state-of-balance value by voltage by reflecting the quantile drop rate, and SOC information about the cells, the quantile order, and estimate the state-of-health balance value by applying the state-of-balance value by voltage to the state-of-health value calculated based on a remaining capacity of the battery.

In addition, the processor may provide a user interface that allows a user to set at least one of the voltage difference allowable limit value and the allowable limit quantile.

In addition, the processor may be configured to calculate a reference deviation voltage value that is a voltage difference per allowable limit quantile, calculate a value of a correction factor based on a standard deviation calculated based on the average voltage and the number of cells, the reference deviation voltage value, and the quantile order, calculate a secondary state-of-balance value by voltage by adding a product of the value of the correction factor and the quantile drop rate to a primary state-of-balance value by voltage that is the state-of-balance value by voltage calculated based on the quantile drop rate and the quantile order, and estimate the state-of-health balance value by applying the secondary state-of-balance value by voltage to the state-of-health value.

In addition, when calculating the secondary state-of-balance value by voltage, the processor may be configured to change the calculated value of the correction factor to zero (0) when the value is a negative number and apply the changed value and apply the calculated value of the correction factor as it is when the value is a positive number.

In addition, the processor may be configured to calculate the amount of power stored in the battery based on a current applied to the battery. In addition, the processor may be configured to convert a Q-V graph showing a relationship between a voltage of the battery and the power storage amount of the battery into a V-dQ/dV graph showing a relationship between the voltage of the battery and the ratio of an amount of change in the power storage amount to an amount of change in the voltage of the battery.

Meanwhile, the processor may detect two feature points including a reference point and a measurement point from the V-dQ/dV graph.

In addition, the processor may be configured to, in reflecting the SOC information about cells in the state of balance by voltage, calculate the state of balance by voltage in which the SOC information is reflected by applying a $dQ_{reference}/dV_{reference}$ value at the reference point and a $dQ_{measurement}/dV_{measurement}$ value at the measurement point.

In addition, the processor may set the voltage difference allowable limit value to be greater than a value obtained by dividing a usage voltage range value that is a difference between the fully charged state voltage and the discharged state voltage by the number of the plurality of cells and smaller than a value obtained by dividing the usage voltage range value by 2.

In addition, the processor may be configured to sequentially increase the quantile order that is a variable in integer units within a range from 1 to the allowable limit quantile, calculate a range of a value obtained by subtracting or adding a value obtained by multiplying a value obtained by dividing the voltage difference allowable limit value by the allowable limit quantile by the quantile order from or to the average voltage value, derive an initial quantile order that includes all measured voltages for each cell within the calculated range, and calculate the state-of-balance value by voltage based on the derived quantile order.

In addition, the processor may determine that the state-of-balance value by voltage is zero (0) when all of the measured voltages for each cell are not included within the calculated range while the quantile order that is a variable is increased to the allowable limit quantile.

Meanwhile, according to another aspect of the present invention, a method for estimating a state of health of a battery by an apparatus for estimating a state of health of a battery includes setting a voltage difference allowable limit value within a voltage difference between a fully charged state voltage of a battery including a plurality of cells and a discharged state voltage thereof, setting an allowable limit quantile that subdivides an allowable limit range to which the voltage difference allowable limit value is applied into one or more analysis sections based on an average voltage value derived from measured voltage values of the cells, calculating a voltage drop rate in the allowable limit range based on the average voltage value, where a quantile drop rate based on the allowable limit quantile is calculated as the voltage drop rate, deriving a quantile order that is an order of an analysis section in which all measured voltage values for each cell are initially included within the allowable limit quantile, determining a power storage amount of the battery based on a current applied to the battery and converting a Q-V graph showing a relationship between a voltage of the battery and the power storage amount of the battery into a V-dQ/dV graph showing a relationship between the voltage of the battery and the ratio of an amount of change in the power storage amount to an amount of change in the voltage of the battery, and calculating the state-of-balance value by voltage based on the quantile drop rate, the quantile order, and V-dQ/dV values of the feature points and estimating the state-of-health balance value by applying the state-of-balance value by voltage to the state-of-health value calculated based on a remaining capacity of the battery.

In this case, the method for estimating a state of health of a battery may further include, prior to the setting of the voltage difference allowable limit value, providing a user interface that allows a user to set at least one of the voltage difference allowable limit value and the allowable limit quantile and receiving at least one of the voltage difference allowable limit value and the allowable limit quantile through the user interface.

In addition, the estimating of the state-of-health balance value may include calculating a reference deviation voltage value that is a voltage difference per allowable limit quantile, calculating a value of a correction factor A based on a standard deviation calculated based on the average voltage and the number of cells, the reference deviation voltage value, and the quantile order, calculating a secondary state-of-balance value by voltage by adding a product of the value of the correction factor A and the quantile drop rate to a primary state-of-balance value by voltage that is the state-of-balance value by voltage calculated based on the quantile drop rate and the quantile order, calculating the dQ/dV value of the reference point and the dQ/dV value of the measurement point based on the V-dQ/dV graph and calculating a correction factor D by dividing the dQ/dV value of the measurement point by the dQ/dV value of the reference point, calculating a tertiary state-of-balance value by voltage by reflecting the correction factor D, and estimating the state-of-health balance value by applying the tertiary state-of-balance value by voltage to the state-of-health value.

The solution to the above problem does not enumerate all the features of the present invention. The various features of the present invention and its advantages and effects may be understood in more detail by referring to the specific examples below.

## ADVANTAGEOUS EFFECTS

According to one embodiment of the present invention, it is possible to more accurately manage a state of balance by voltage between cells of a battery constituting a battery pack by reflecting SOC information about the cells, and possible to predict and take action in advance before a battery in which the state of balance by voltage of the cells is broken reaches a dangerous situation.

In addition to the above effects, specific effects of the present invention will be described together while describing specific details for carrying out the present invention.

## BRIEF DESCRIPTION OF THE DRAWINGS

FIG. 1 is one example of a graph showing a deviation in capacity of cells according to battery use.
FIG. 2 is a configuration diagram of an apparatus for estimating a state of health of a battery according to one embodiment of the present invention.
FIG. 3 is a flowchart for describing a method for estimating a state of health of a battery based on a state of balance by voltage according to one embodiment of the present invention.
FIG. 4 is one example of a graph for describing a voltage deviation according to an SOC of cells.
FIG. 5 is a graph illustrating a V-dQ/dV graph (b) obtained from a Q-V graph (a).
FIG. 6 is one example of a graph for describing a method for estimating a state of health of a battery reflecting a state of balance by voltage of cells according to one embodiment of the present invention.

## MODE FOR CARRYING OUT THE INVENTION

Hereinafter, principles of preferred embodiments of the present invention will be described in detail with reference to the accompanying drawings and description. However, the drawings shown below and the description below are for preferred implementation methods among various methods for effectively describing features of the present invention, and the present invention is not limited to the drawings and description below.

Meanwhile, terms such as first or second may be used to describe various elements, but the terms are to be interpreted only for the purpose of distinguishing one element from another element. For example, a first element may be termed a second element, and similarly, a second element may also be termed a first element.

The singular forms, "a", "an", and "the" are intended to include the plural forms as well, unless the context clearly indicates otherwise. In the present specification, it should be understood that the terms "includes" and/or "including" specify the presence of described features, integers, steps, operations, elements, components, and/or groups thereof, but do not preclude the presence or addition of one or more other features, integers, steps, operations, elements, components, and/or groups thereof.

Unless otherwise defined, all terms used herein, including technical or scientific terms, have the same meaning as commonly understood by those of ordinary skill in the art. Terms, such as those defined in commonly used dictionaries, should be interpreted as having a meaning that is consistent with their meaning in the context of the related art and will not be interpreted in an idealized or overly formal sense unless expressly so defined herein.

In the following, a process for estimating a state of health of a battery according to one embodiment of the present invention will be described with reference to the attached drawings.

First, FIG. 2 is a configuration diagram of an apparatus for estimating a state of health of a battery according to one embodiment of the present invention.

A battery state-of-health estimation apparatus 100 shown in FIG. 2 may be a computing device that operates by at least one processor. Further, the battery state-of-health estimation apparatus 100 may execute a program containing instructions described to execute operations according to the present invention.

The apparatus 100 may be included in a battery management system (BMS) (not shown) provided in a battery pack.

As shown in FIG. 2, the hardware of the battery state-of-health estimation apparatus 100 may include at least one processor 110, memory 120, storage 130, and communication interface 140, and each component may be connected via a bus.

In addition, the battery state-of-health estimation apparatus 100 may further include hardware such as a separate input device, an output device, or the like.

In addition, the battery state-of-health estimation apparatus 100 may be equipped with various software, including an operating system capable of running programs, on a storage device such as the storage 130.

The processor 110 is a device that controls the operation of the computing device 100, and may be various types of processors (e.g., a central processing unit (CPU), a micro processor unit (MPU), a micro controller unit (MCU), a graphic processing unit (GPU), and the like) that process instructions included in programs.

The memory 120 may load a corresponding program so that instructions described to execute operations according to the present invention are processed by the processor 110. For example, the memory 120 may be a read only memory (ROM), a random access memory (RAM), or the like.

The storage 130 may store various data and programs required to execute operations according to the present invention. In this case, the storage 130 may store result data processed according to the execution of the program and measurement data input through a previously linked or connected device (e.g., a battery management system (BMS) or the like) by matching them for each battery and forming a database.

The communication interface 140 may be a wired/wireless communication module that handles communication between respective components of the computing device 100 and communication with externally linked devices.

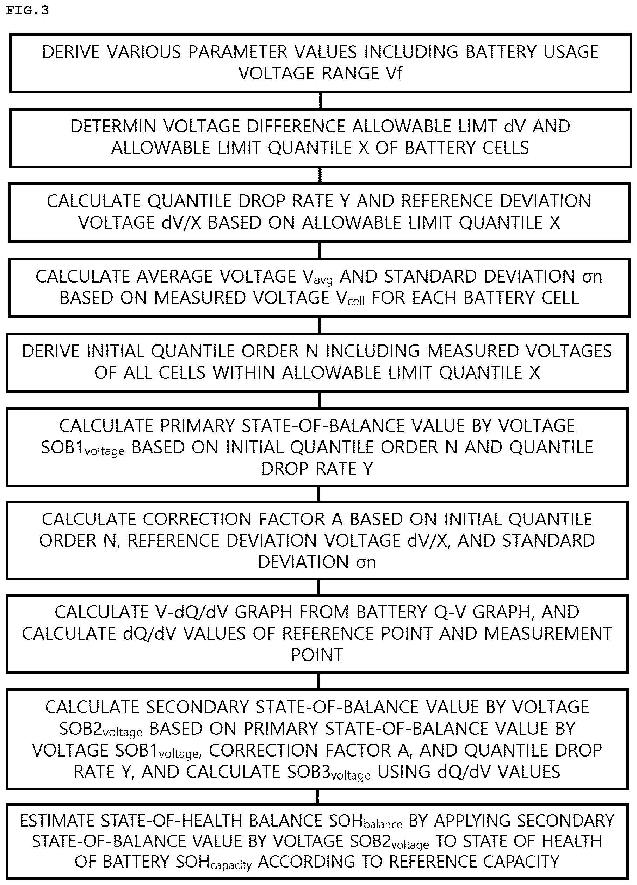

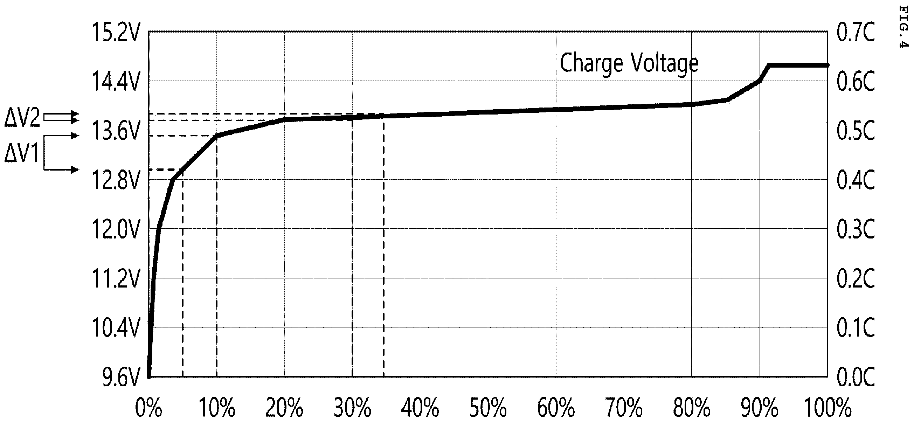

FIG. 3 is a flowchart illustrating a process in which the battery state-of-health estimation apparatus according to one embodiment of the present invention estimates an accurate state of health of a battery based on a state of balance by voltage of battery cells. In addition, FIG. 4 is one example of a graph for describing a voltage deviation according to an SOC of a battery.

The battery state-of-health estimation apparatus 100 according to an embodiment of the present invention may calculate the state of balance by voltage $SOB_{voltage}$ between the battery cells by reflecting SOC information and calculate the state-of-health balance $SOH_{balance}$ by applying the state of balance by voltage $SOB_{voltage}$ of battery cells to a reference state of health $SOH_{capacity}$ according to a thermodynamic standard capacity (that is, the state of charge (SOC)) for the battery.

In a battery including a plurality of single cells (that is, cells), the state of balance by voltage (SOB) is a factor indicating the degree of voltage equalization of the single cells. That is, the state of balance by voltage (SOB) is a value that allows checking how much a voltage state of each single cell of the battery differs from an average voltage at any given point in time.

By calculating the state-of-health balance $SOH_{balance}$, to which the actual state of balance by voltage between the single cells is applied, it is possible to estimate the accurate state of health of the battery under actual use environments. That is, whereas in the related art, estimating the state of health of the battery is limited to information such as the average voltage value and the standard deviation of cells, the method for estimating a state of health of a battery according to one embodiment of the present invention may estimate the state of health of the battery by applying even whether the state of balance by voltage between battery cells is at a level that allows stable battery operation and the SOC information about the cells.

In this regard, the SOB in the related art is calculated through the voltage distribution of cells at an arbitrary point in time, that is, voltage distribution information such as the average voltage and standard deviation of the voltage of the cells constituting the battery pack. However, even when the charge amount deviation of the cells constituting the battery pack shows the same distribution, the voltage deviation may significantly differ depending on the arbitrary point in time at which the voltage is measured, that is, the arbitrary SOC, and thus in some cases, the SOB may be measured in a distorted manner.

For example, in an SOC-voltage curve of FIG. 4 showing the SOC and voltage of cells, looking at the change in voltage according to the state of charge, it can be seen that a difference between a voltage difference ($\triangle$V1) of 5% and 10% of SOC and a voltage difference ($\triangle$V2) of 30% and 35% of SOC is very large. The charged capacity difference (SOC difference) of the cells constituting the battery pack is the same, but the voltage distribution of the cells varies greatly depending on the SOC for which the battery voltage is measured.

That is, assuming that there is a battery pack including two cells, a pack with one cell of 5% of SOC and one cell 10% of SOC, and a pack with one cell of 35% of SOC and one cell of 40% of SOC differ only in the SOC at the time of measurement, but severe distortion occurs in the voltage deviation. Accordingly, in the present invention, the present inventors have made much effort to supplement the method for calculating SOB only through the voltage distribution in the related art, and have arrived at the present invention.

Meanwhile, referring to FIG. 3, the processor 110 may process the following operations by executing a series of instructions included in the program, and in this way, the state-of-health balance $SOH_{balance}$ of the battery in which the state of balance by voltage of the battery cell is reflected may be estimated and output.

First, values of preset parameters are derived based on basic information and actual measurement information in information for each battery stored in the storage 140.

In this case, the preset parameters may include a "fully charged state voltage $V_{cha}$" applied to the single cells of the battery, a "discharged state voltage $V_{dis}$" applied to the single cells of the battery, a "maximum voltage $V_{max}$" among measured voltages of each of the single cells of the battery, a "minimum voltage $V_{min}$" among the measured voltages of each of the single cells of the battery, an "average voltage $V_{avg}$" for the measured voltages of the single cells of the battery, the "number n" of the single cells constituting the battery, a maximum "operating voltage range $V_f$" of the battery, and a "voltage standard deviation $\sigma n$" for the single cells of the battery.

Specifically, the voltage range at which the battery is able to be used, that is, the maximum operating voltage range $V_f$, may be defined as Equation 1 below.

<Equation 1>

$$V_f = (V_{cha} - V_{dis})$$

As described above, $V_{cha}$ is the fully charged state voltage of the single cells constituting the battery, and $V_{dis}$ is the discharged state voltage of the single cells. That is, a difference between the maximum charge voltage and maximum discharge voltage of the battery may be defined as the voltage range value $V_f$ in which the battery is capable of being used.

The battery usage voltage range $V_f$ defined as above is calculated.

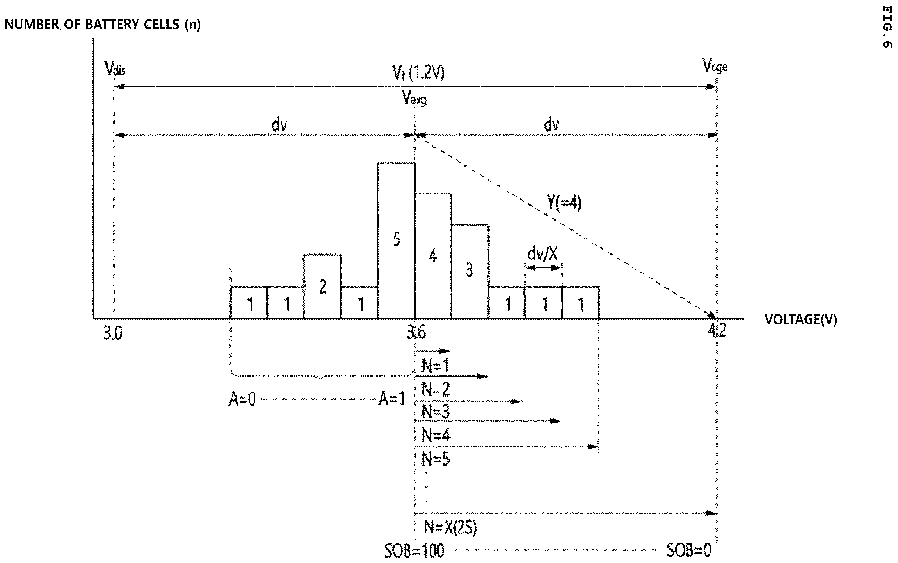

For example, referring to FIG. 6, when the fully charged state voltage $V_{cha}$ is set to 4.2 V and the discharged state voltage $V_{dis}$ is set to 3.0 V in any lithium ion battery, the usage voltage range $V_f$ may be calculated as 1.2 V.

In order to estimate the state of balance by voltage SOB of the single cells of the corresponding battery based on each parameter derived in this way, the following two parameters dV and X are determined.

A maximum allowable voltage difference between the single cells within the previously determined usage voltage range $V_f$, that is, a voltage difference allowable limit dV, is determined. The voltage difference allowable limit dV is a parameter that may be specified by a user to set an appropriate range of the state of balance by voltage (SOB), and the value of the range is not limited.

In this case, the processor 110 may provide a user interface that allows a user (e.g., a battery examiner, battery use system designer, or the like) to select the voltage difference allowable limit dV. The user interface provided through the processor 110 is a concept that includes a graphical user interface (GUI).

In this way, the value of the voltage difference allowable limit dV may be input in real time or in advance through the user interface provided by the processor 110, and this user interface may include recommended values of the voltage difference allowable limit dV, allowing the user to select a dV value suitable for the desired state of balance by voltage of the cells of the battery among the recommended dVs.

The voltage difference allowable limit dV may be determined according to the conditions of Equation 2 below.

<Equation 2>

$$\frac{V_f}{n} \leq dV \leq \frac{V_f}{2}$$

That is, the voltage difference allowable limit dV between the single cells of the battery may be set to be greater than or equal to a value obtained by dividing the usage voltage range $V_f$ by the number of single cells n, but not more than 0.5 times the usage voltage range.

In the case of the lithium ion battery according to the example in FIG. 6, it is shown that the usage voltage range $V_f$ is 1.2 V, and the value of the voltage difference allowable limit dV is determined to be "1.2 V/2=0.6 V", which is the maximum value in the voltage difference allowable limit range. In FIG. 6, it is shown as an example that dV is the maximum value of $V_f/2$, but dV is not limited thereto, and the narrower the allowable limit range to which dV is applied based on the average voltage $V_{avg}$ is set, the greater the efficiency of applying the state of balance by voltage may be.

Referring to FIG. 6, the average voltage $V_{avg}$ derived from the measured voltage of the single cells is 3.6 V, and voltage difference ranges from the average voltage $V_{avg}$ to 0.6 V in a negative direction and 0.6 V in the positive direction, respectively, may be determined as the allowable limit range.

Next, in order to determine a balance precision of the distribution within the voltage difference allowable limit range, an allowable limit quantile X, which is the number of analysis sections within the voltage difference allowable limit range, is determined.

For example, the allowable limit quantile X may be determined according to conditions of Equation 3 below.

<Equation 3>

$$3 \leq X \leq n^2$$

As in Equation 3, the allowable limit quantile X may be set to a number greater than or equal to 3 and less than or equal to 2nd power of the number n of the single cells.

In this case, the processor 110 may provide a user interface that allows the user (e.g., the battery examiner, battery use system designer, or the like) to select the number of allowable limit quantiles X.

The user interface provided through the processor 110 is a concept that includes a graphical user interface (GUI). In this way, the value of the allowable limit quantile X may be input in real time or in advance through the user interface provided by the processor 110, and this user interface may include recommended values of the allowable limit quantile X, allowing the user to select an X value suitable for the desired precision of the battery among the recommended Xs.

In this way, in a state in which the voltage difference allowable limit range dV and the allowable limit quantile X are determined, a quantile drop rate Y is determined. The quantile drop rate Y refers to a voltage drop rate in the allowable limit range based on the average voltage. For example, the quantile drop rate Y may be defined as Equation 4 below.

<Equation 4>

$$Y = 100/X$$

In the lithium ion battery according to the example of FIG. 6, when the allowable limit quantile X is determined to be 25, the quantile drop rate Y is 4.

In addition, in the lithium ion battery according to the example in FIG. 6, since the usage voltage range $V_f$ is 1.2 V and the voltage difference allowable limit dV is 0.6 V, a reference deviation voltage dV/X, which refers to the voltage difference per allowable limit quantile, may be calculated as "0.6/25 = 0.024."

Then, the average voltage $V_{avg}$ and standard deviation on are calculated based on the measured voltage value $V_{cell}$ of each of the single cells $V_1$ to $V_n$ of the battery.

For example, the standard deviation on may be calculated using Equation 5 below.

<Equation 5>

$$\sigma n = \sqrt{\frac{\sum(V_n - V_{avg})^2}{n}}$$

In the lithium ion battery according to the example of FIG. 6, since the average voltage $V_{avg}$ calculated based on the measured voltage $V_{cell}$ measured for each cell (that is, the single cell) is 3.6 V, the standard deviation on may be calculated as 0.187.

Next, a quantile order N, which includes all voltage values of each measured cell, is calculated. The quantile order N refers to an integer that increases sequentially from 1 to the allowable limit quantile X.

In this case, the quantile order N may be determined using Equation 6 below.

<Equation 6>

$$V_{avg} \pm N\left(\frac{dV}{X}\right)$$

As in Equation 6, the quantile order N may be determined based on the average voltage value $V_{avg}$ of the single cells and the reference deviation voltage dV/X.

In the lithium ion battery according to the example in FIG. 6, when the average voltage $V_{avg}$ is 3.6 V and the reference deviation voltage dV/X is 0.024, the first quantile order N, which includes the measured voltages of all cells, may be 5.

Specifically, an initial quantile order N, which includes the voltage values of all individual cells (that is, single cells), may be obtained by calculating the number of $V_{cell}$s satisfying conditions in Equation 7 below when the quantile order N, which is a variable, is sequentially increased in integer units from 1 to X.

<Equation 7>

$$V_{avg} - N\left(\frac{dV}{X}\right) \leq V_{cell} \leq V_{avg} + N\left(\frac{dV}{X}\right)$$

When a result in Equation 6 above is expressed as a percentage of n, the quantile order N that initially becomes 100 (that is, the measured voltages of all single cells are included in the range) may be derived. That is, while dividing the quantiles by increasing the quantile order N by 1, the initial quantile order N that includes the measured voltages of all single cells within the range from the average voltage $V_{avg}$ to the determined allowable limit dV is determined.

Next, the state-of-balance value by voltage $SOB_{voltage}$ for the single cells is calculated based on the quantile order N calculated through Equations 6 and 7 above.

$SOB1_{voltage}$, which is the primary state-of-balance value by voltage, may be calculated using Equation 8 below.

<Equation 8>

$$SOB1_{voltage} = (100 - Y * N)$$

For reference, when the quantile order N that initially becomes 100 is not found, when expressed as a percentage of n until the quantile order N, which is a variable, becomes X, $SOB1_{voltage}$ is determined to be 0.

On the other hand, when the quantile order N that initially becomes 100 is any one of 1 to X when expressed as a percentage of n until the quantile order N, which is a variable, becomes X, $SOB1_{voltage}$ is calculated as 100 - Y*N as in Equation 8, and Y=100/X.

In the lithium ion battery according to the example in FIG. 6, since the quantile order N is 5 and Y is 4, $SOB1_{voltage}$ is calculated as 80 by "100 - 4*5."

Meanwhile, an intra-quantile balance correction factor A may be calculated from the standard deviation $\sigma n$ and the reference deviation voltage dV/X, and a secondary state-of-balance value by voltage $SOB2_{voltage}$ may be calculated using the correction factor A.

The correction factor A may be obtained using Equation 9 below, and the secondary state-of-balance value by voltage $SOB2_{voltage}$ may be obtained using Equation 10.

$$<\text{Equation 9}>$$

$$A = \frac{\left(N * \dfrac{dV}{X}\right) - \sigma n}{\left(N * \dfrac{dV}{X}\right)}$$

The correction factor A is a balance correction factor of each quantile.

In the lithium ion battery according to the example in FIG. 6, since the quantile order N is 5, the reference deviation voltage dV/X is 0.024, and the standard deviation $\sigma n$ is 0.02, the correction factor A is determined to be 0.83 by "(5*0.024 - 0.02)/(5*0.024)."

$$<\text{Equation 10}>$$

$$SOB2_{voltage} = SOB1_{voltage} + A'*Y$$

$$(\text{if } A>0: A'=A, \ A\leq0: A'=0)$$

As in Equation 10, the secondary state-of-balance value by voltage $SOB2_{voltage}$ is calculated based on the product of the primary state-of-balance value by voltage $SOB1_{voltage}$, the correction factor A, and quantile drop rate Y. In this case, when the correction factor A is negative, A' is set to 0, and when the A value is positive, A' is set to the A value.

In the lithium ion battery according to the example in FIG. 6, since the correction factor A is a positive number of 0.83, A' is set to 0.83, and as a result, the secondary state-of-balance value by voltage $SOB2_{voltage}$ is determined to be "83.32" by "80 + 0.83*4."

Meanwhile, $SOB1_{voltage}$ and $SOB2_{voltage}$ reflect the voltage distribution of the cells constituting the battery pack, but as described above, do not reflect the SOC information at the time of measuring SOB, so even when the cells show the same distribution of the charge amount, depending on the measured SOC, the voltage difference between the cells is large, so that SOB may be differently calculated.

Therefore, it is necessary to calculate the state-of-balance value by voltage $SOB3_{voltage}$ by reflecting the SOC information about the cells constituting the battery pack.

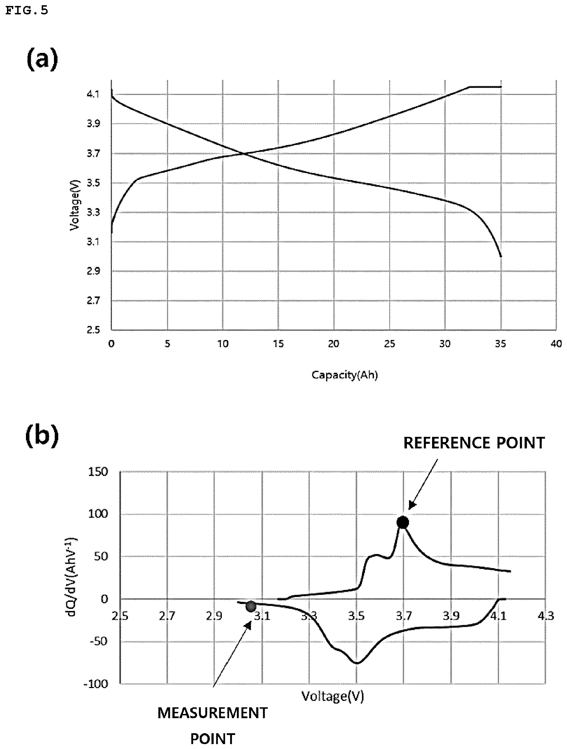

Referring to FIG. 5, the processor 110 converts a V-Q graph (or a function corresponding to the V-Q graph) of the battery into a V-dQ/dV graph. Here, dQ/dV represents the ratio of the amount of change dQ in the power storage amount of the battery to the amount of change dV in the voltage of the battery. That is, the processor 110 may generate V-dQ/dV illustrated in FIG. 5 by differentiating the V-Q graph (or a function corresponding to the V-Q graph) with respect to a voltage V of the battery. V-dQ/dV is a graph showing a relationship between the battery voltage V and dQ/dV.

Next, the processor 110 may detect two feature points (reference point and measurement point) on the V-dQ/dV graph. In addition, the processor is configured to, in reflecting the SOC information about cells in the state of balance by voltage, calculate the state of balance by voltage in which the SOC information is reflected by applying a $dQ_{reference}/dV_{reference}$ value at the reference point and a $dQ_{measurement}/dV_{measurement}$ value at the measurement point.

Here, for SOB3$_{voltage}$ to reflect the voltage change according to SOC, a correction factor D may be calculated using<Equation 11> below, and SOB3$_{voltage}$ may be calculated by reflecting the correction factor D.

Here, the dQ/dV value is the ratio of the amount of change in the capacity to the amount of change in the voltage, and by applying a dQ/dV value of a voltage measurement point compared to a specific reference point to the SOB calculation, a difference in voltage change according to SOC may be offset.

<Equation 11>

$$D = \left(\frac{dQ_{measurement}}{dV_{measurement}}\right) / \left(\frac{dQ_{reference}}{dV_{reference}}\right)$$

In this case, the reference point of (dQ$_{reference}$/dV$_{reference}$) may be any point within the voltage range in which the cells are driven, and preferably, any voltage point among points of 30 to 70% of SOC may be used as the reference point.

In this case, since (dQ$_{reference}$/dV$_{reference}$) calculated from the same reference point is applied within the same cell or the same battery, even when (dQ$_{reference}$/dV$_{reference}$) is measured at an arbitrary point, relative SOB may be calculated within the same cell or same battery.

Meanwhile, the processor 110 may remove noise components of the V-dQ/dV graph using a noise filter prior to detecting feature points on the V-dQ/dV graph. By preventing the phenomenon of misdetecting feature points from the V-dQ/dV graph of FIG. 5 due to the noise component present in V-dQ/dV of FIG. 3, the accuracy of feature point detection may be improved. Of course, smoothing the V-dQ/dV graph is an optional process.

FIG. 5 shows an example in which two feature points located on a V-dQ/dV graph are detected by the processor 110.

In addition, as shown in Equation 12 below, a tertiary state-of-balance value by voltage SOB3$_{voltage}$ is calculated by reflecting the correction factor D in the primary state-of-balance value by voltage SOB1$_{voltage}$ and the secondary state-of-balance value by voltage SOB2$_{voltage}$.

<Equation 12>

$$SOB3 = 100 - Y * N * D + A' * Y$$

Next, by correcting the state of health SOH of the battery using the tertiary state-of-balance value by voltage SOB3$_{voltage}$, the state-of-health balance SOH$_{balance}$ to which the state of balance by voltage is applied is calculated.

The state of health of the battery SOH$_{balance}$ to which the state of balance by voltage of the battery is applied may be calculated using Equation 13 below.

<Equation 13>

$$SOH_{balance} = SOB3_{voltage} * SOH_{capacity}$$

In this case, SOH$_{capacity}$ represents a lifespan based on the the remaining capacity (SOC) of the battery, and SOH$_{balance}$ represents a lifespan obtained by applying the state of balance by voltage to the lifespan based on the remaining capacity of the battery.

As described above, since the average value, standard deviation, and limit quantile alone may not accurately express the state of balance of the cells of the battery, the state of health of the battery to which a more accurate state of balance by voltage is applied may be estimated by reflecting the SOC of the cells.

Referring to Table 1 and Table 2 below, let's look at the state of battery by voltage SOB of the battery. Table 1 and Table 2 below are measurements using the same battery, and the SOB is calculated at different voltage bands after completely discharging.

<Table 1>

| Single cell measurement voltage | | | | | | | | | |
|---|---|---|---|---|---|---|---|---|---|
| V(1) | V(2) | V(3) | V(4) | V(5) | V(6) | V(7) | V(8) | V(9) | V(10) |
| 3.133 | 3.120 | 3.122 | 3.072 | 3.121 | 3.114 | 3.114 | 3.124 | 3.116 | 3.122 |
| V(11) | V(12) | V(13) | V(14) | V(15) | V(16) | V(17) | V(18) | V(19) | V(20) |
| 3.130 | 3.093 | 3.101 | 3.071 | 3.096 | 3.079 | 3.081 | 3.067 | 3.091 | 3.108 |
| Various parameters | | | | | | | | | |
| n | Vcha | Vdis | Vf | Vmax | Vmin | Vavg | dv | Vmax-Vavg | Vavg-Vmin |
| 20 | 4.15 | 3.1 | 1.05 | 3.133 | 3.067 | 3.104 | 0.105 | 0.066 | 0.037 |
| SOB=0? | SOB=100? | X | dV/X | Stdev | N | Y | SO81 | | |
| NO | NO | S0 | 0.0021 | 0.0205 | 18 | 2 | 64 | | |
| A | A | SOB2 | | | dQ/dV(reference) | dQ/dV(measurement) | SOB3 | | |
| 0.4583 | 0.4583 | 64.917 | | | 16.639 | 1.665 | 97.314 | | |
| Cell inclusion rate by quantile section | | | | | | | | | |
| 1st section | 2nd section | 3rd section | 4th section | 5th section | 6th section | 7th section | 8th section | 9th section | 10th section |
| 0 | 10 | 15 | 20 | 30 | 35 | 40 | 45 | 60 | 65 |
| 11th section | 12th section | 13th section | 14th section | 15th section | 16th section | 17th section | 18th section | 19th section | 20th section |
| 70 | 75 | 80 | 85 | 85 | 95 | 95 | 100 | 100 | 100 |
| 21st section | 22nd section | 23rd section | 24th section | 25th section | 26th section | 27th section | 28th section | 29th section | 30th section |
| 100 | 100 | 100 | 100 | 100 | 100 | 100 | 100 | 100 | 100 |
| 31st section | 32nd section | 33rd section | 34th section | 35th section | 36th section | 37th section | 38th section | 39th section | 40th section |
| 100 | 100 | 100 | 100 | 100 | 100 | 100 | 100 | 100 | 100 |
| 41st section | 42nd section | 43rd section | 44th section | 45th section | 46th section | 47th section | 48th section | 49th section | 50th section |
| 100 | 100 | 100 | 100 | 100 | 100 | 100 | 100 | 100 | 100 |

<Table 2>

| V(1) | V(2) | V(3) | V(4) | V(5) | V(6) | V(7) | V(8) | V(9) | V(10) |
|---|---|---|---|---|---|---|---|---|---|
| 3.996 | 3.997 | 3.997 | 3.997 | 3.995 | 3.997 | 3.997 | 3.997 | 3.998 | 4.001 |
| V(11) | V(12) | V(13) | V(14) | V(15) | V(16) | V(17) | V(18) | V(19) | V(20) |
| 4.001 | 3.999 | 3.998 | 4.000 | 3.998 | 3.997 | 3.997 | 3.997 | 4.003 | 4.004 |
| Various parameters | | | | | | | | | |
| n | Vcha | Vdis | Vf | Vmax | Vmin | Vavg | dv | Vmax-Vavg | Vavg-Vmin |
| 20 | 4.15 | 3.1 | 1.05 | 4.004 | 3.996 | 3.998 | 0.105 | 0.008 | 0.002 |
| SOB=0? | SOB=100? | X | dV/X | Stdev | N | Y | SO81 | | |
| NO | NO | S0 | 0.0021 | 0.00222 | 3 | 2 | 94 | | |

(continued)

| Various parameters | | | | | | | | | |
|---|---|---|---|---|---|---|---|---|---|
| A | A' | SOB2 | | | dQ/dV(reference) | dQ/dV(measurement) | SOB3 | | |
| 0.6477 | 0.6477 | 95.295 | | | 16.639 | 7.492 | 98.594 | | |
| Cell inclusion rate by quantile section | | | | | | | | | |
| 1st section | 2nd section | 3rd section | 4th section | 5th section | 6th section | 7th section | 8th section | 9th section | 10th section |
| 80 | 90 | 100 | 100 | 100 | 100 | 100 | 100 | 100 | 100 |
| 11th section | 12th section | 13th section | 14th section | 15th section | 16th section | 17th section | 18th section | 19th section | 20th section |
| 100 | 100 | 100 | 100 | 100 | 100 | 100 | 100 | 100 | 100 |
| 21st section | 22nd section | 23rd section | 24th section | 25th section | 26th section | 27th section | 28th section | 29th section | 30th section |
| 100 | 100 | 100 | 100 | 100 | 100 | 100 | 100 | 100 | 100 |
| 31st section | 32nd section | 33rd section | 34th section | 35th section | 36th section | 37th section | 38th section | 39th section | 40th section |
| 100 | 100 | 100 | 100 | 100 | 100 | 100 | 100 | 100 | 100 |
| 41st section | 42nd section | 43rd section | 44th section | 45th section | 46th section | 47th section | 48th section | 49th section | 50th section |
| 100 | 100 | 100 | 100 | 100 | 100 | 100 | 100 | 100 | 100 |

Tables 1 and 2 are data collected during a subsequent charging process after completely discharging all cells constituting the battery pack, and since the SOB was measured immediately after performing complete discharging, the balance would not be significantly lost, so that it may be assumed that deviation of the SOB will not be large.

<Table 1> shows data obtained by measuring the voltage distribution of cells around 3.1 V that is an area where the voltage deviation according to the SOC is very large. In this case, SOB2 calculated by simply reflecting the voltage distribution and limit quantile of the cells was 64.917, but SOB3 calculated by reflecting the correction factor D for the SOC was calculated as 97.314. That is, it can be seen that there is a very large difference in the values of the SOB in which SOC information is reflected and SOB in which SOC information is not reflected.

On the other hand, <Table 2> shows data obtained by measuring the voltage distribution of cells around 4.0 V that is an area where the voltage deviation according to the SOC is small. Here, SOB2 was calculated as 95.295, and SOBS reflecting the correction factor D, was calculated as 98.594.

Although it is assumed that the SOBs are similar SOBs in this way, it can be seen that the difference between the calculated SOBs is very large depending on the measuring point in time, and it can be seen that when the SOB is calculated by reflecting the correction factor D, more accurate measurement is possible.

Although the preferred embodiments of the present invention have been described in detail above, the scope of the present invention is not limited thereto, and various modifications and improvements made by those skilled in the art using the basic concept of the present invention defined in the following claims also fall within the scope of the present invention.

100:    Battery state-of-health estimation apparatus
110:    Processor
120:    Memory
130:    Storage
140:    Communication interface.

**Claims**

1.    An apparatus for estimating a state of health of a battery, the apparatus comprising:

        a memory configured to load a program for calculating a state-of-balance value by voltage of a plurality of cells constituting a battery and estimating a state-of-health balance value that is a state-of-health value of the battery to which the state-of-balance value by voltage is applied; and

a processor configured to execute instructions included in the program loaded by the memory, wherein the processor is configured to, according to execution of the program:

set a voltage difference allowable limit value within a voltage difference between a fully charged state voltage of the battery and a discharged state voltage thereof and set an allowable limit quantile that subdivides an allowable limit range to which the voltage difference allowable limit value is applied into one or more analysis sections based on an average voltage value derived from measured voltage values of the cells;

calculate a quantile drop rate that is a voltage drop rate in the allowable limit range based on the average voltage value, wherein a quantile order that is an order of an analysis section in which all measured voltage values for each cell are initially included within the allowable limit quantile is derived;

determine a power storage amount of the battery based on a current applied to the battery and convert a Q-V graph showing a relationship between a voltage of the battery and the power storage amount of the battery into a V-dQ/dV graph showing a relationship between the voltage of the battery and the ratio of an amount of change in the power storage amount to an amount of change in the voltage of the battery;

detect feature points including a reference point and a measurement point from the V-dQ/dV graph; and

calculate the state-of-balance value by voltage based on the quantile drop rate, the quantile order, and dQ/dV values of the feature points and estimate the state-of-health balance value by applying the state-of-balance value by voltage to the state-of-health value calculated based on a remaining capacity of the battery, and the quantile drop rate is calculated using the following equation;

$$Y = 100/X$$

where Y is the quantile drop rate of the battery meaning the voltage drop rate in the allowable limit range based on the average voltage and X is the allowable limit quantile.

2. The apparatus of claim 1, wherein the processor is configured to:

calculate a reference deviation voltage value that is a voltage difference per allowable limit quantile;

calculate a value of a correction factor A based on a standard deviation calculated based on the average voltage and the number of cells, the reference deviation voltage value, and the quantile order;

calculate a secondary state-of-balance value by voltage by adding a product of the value of the correction factor and the quantile drop rate to a primary state-of-balance value by voltage that is the state-of-balance value by voltage calculated based on the quantile drop rate and the quantile order;

calculate the dQ/dV value of the reference point and the dQ/dV value of the measurement point based on the V-dQ/dV graph;

calculate a correction factor D by dividing the dQ/dV value of the measurement point by the dQ/dV value of the reference point;

calculate a tertiary state-of-balance value by voltage by reflecting the correction factor D; and

estimate the the state-of-health balance value by applying the tertiary state-of-balance value by voltage to the state-of-health value.

3. The apparatus of claim 2, wherein when calculating the secondary state-of-balance value by voltage, the processor changes the calculated value of the correction factor A to zero (0) when the value is a negative number and applies the changed value and applies the calculated value of the correction factor A as it is when the value is a positive number.

4. The apparatus of claim 1, wherein the processor sets the voltage difference allowable limit value to be greater than a value obtained by dividing a usage voltage range value that is a difference between the fully charged state voltage and the discharged state voltage by the number of the plurality of cells and smaller than a value obtained by dividing the usage voltage range value by 2.

5. A method for estimating a state of health of a battery by an apparatus for estimating a state of health of a battery, the method comprising:

setting a voltage difference allowable limit value within a voltage difference between a fully charged state voltage of a battery including a plurality of cells and a discharged state voltage thereof;

setting an allowable limit quantile that subdivides an allowable limit range to which the voltage difference allowable limit value is applied into one or more analysis sections based on an average voltage value derived from measured voltage values of the cells;

calculating a quantile drop rate that is a voltage drop rate in the allowable limit range based on the average voltage value, based on the allowable limit quantile;

deriving a quantile order that is an order of an analysis section in which all measured voltage values for each cell are initially included within the allowable limit quantile;

determining a power storage amount of the battery based on a current applied to the battery and converting a Q-V graph showing a relationship between a voltage of the battery and the power storage amount of the battery into a V-dQ/dV graph showing a relationship between the voltage of the battery and the ratio of an amount of change in the power storage amount to an amount of change in the voltage of the battery;

detecting feature points including a reference point and a measurement point from the V-dQ/dV graph; and

calculating the state-of-balance value by voltage based on the quantile drop rate, the quantile order, and dQ/dV values of the feature points and estimating the state-of-health balance value by applying the state-of-balance value by voltage to the state-of-health value calculated based on a remaining capacity of the battery;

$$Y = 100/X$$

where Y is the quantile drop rate of the battery meaning the voltage drop rate in the allowable limit range based on the average voltage and X is the allowable limit quantile.

6. The method of claim 5, wherein the estimating of the state-of-health balance value includes:

calculating a reference deviation voltage value that is a voltage difference per allowable limit quantile;

calculating a value of a correction factor A based on a standard deviation calculated based on the average voltage and the number of cells, the reference deviation voltage value, and the quantile order;

calculating a secondary state-of-balance value by voltage by adding a product of the value of the correction factor and the quantile drop rate to a primary state-of-balance value by voltage that is the state-of-balance value by voltage calculated based on the quantile drop rate and the quantile order;

calculating the dQ/dV value of the reference point and the dQ/dV value of the measurement point based on the V-dQ/dV graph and calculating a correction factor D by dividing the dQ/dV value of the measurement point by the dQ/dV value of the reference point;

calculating a tertiary state-of-balance value by voltage by reflecting the correction factor D; and

estimating the the state-of-health balance value by applying the tertiary state-of-balance value by voltage to the state-of-health value.

FIG.1

FIG.2

**FIG.3**

DERIVE VARIOUS PARAMETER VALUES INCLUDING BATTERY USAGE VOLTAGE RANGE Vf

DETERMIN VOLTAGE DIFFERENCE ALLOWABLE LIMT dV AND ALLOWABLE LIMIT QUANTILE X OF BATTERY CELLS

CALCULATE QUANTILE DROP RATE Y AND REFERENCE DEVIATION VOLTAGE dV/X BASED ON ALLOWABLE LIMIT QUANTILE X

CALCULATE AVERAGE VOLTAGE $V_{avg}$ AND STANDARD DEVIATION $\sigma n$ BASED ON MEASURED VOLTAGE $V_{cell}$ FOR EACH BATTERY CELL

DERIVE INITIAL QUANTILE ORDER N INCLUDING MEASURED VOLTAGES OF ALL CELLS WITHIN ALLOWABLE LIMIT QUANTILE X

CALCULATE PRIMARY STATE-OF-BALANCE VALUE BY VOLTAGE $SOB1_{voltage}$ BASED ON INITIAL QUANTILE ORDER N AND QUANTILE DROP RATE Y

CALCULATE CORRECTION FACTOR A BASED ON INITIAL QUANTILE ORDER N, REFERENCE DEVIATION VOLTAGE dV/X, AND STANDARD DEVIATION $\sigma n$

CALCULATE V-dQ/dV GRAPH FROM BATTERY Q-V GRAPH, AND CALCULATE dQ/dV VALUES OF REFERENCE POINT AND MEASUREMENT POINT

CALCULATE SECONDARY STATE-OF-BALANCE VALUE BY VOLTAGE $SOB2_{voltage}$ BASED ON PRIMARY STATE-OF-BALANCE VALUE BY VOLTAGE $SOB1_{voltage}$, CORRECTION FACTOR A, AND QUANTILE DROP RATE Y, AND CALCULATE $SOB3_{voltage}$ USING dQ/dV VALUES

ESTIMATE STATE-OF-HEALTH BALANCE $SOH_{balance}$ BY APPLYING SECONDARY STATE-OF-BALANCE VALUE BY VOLTAGE $SOB2_{voltage}$ TO STATE OF HEALTH OF BATTERY $SOH_{capacity}$ ACCORDING TO REFERENCE CAPACITY

FIG.4

EP 4 478 069 A1

FIG.5

**(a)**

Voltage(V) vs Capacity(Ah)

**(b)**

REFERENCE POINT

dQ/dV(AhV⁻¹) vs Voltage(V)

MEASUREMENT
POINT

19

FIG. 6

## INTERNATIONAL SEARCH REPORT

| | International application No. |
|---|---|
| | **PCT/KR2022/019484** |

**A. CLASSIFICATION OF SUBJECT MATTER**

**G01R 31/392**(2019.01)i; **G01R 19/165**(2006.01)i; **G01R 31/3842**(2019.01)i; **G01R 31/396**(2019.01)i; **G01R 19/00**(2006.01)i; **G01R 19/10**(2006.01)i

According to International Patent Classification (IPC) or to both national classification and IPC

**B. FIELDS SEARCHED**

Minimum documentation searched (classification system followed by classification symbols)

G01R 31/392(2019.01); G01R 19/12(2006.01); G01R 31/36(2006.01); H01M 10/42(2006.01); H01M 10/48(2006.01); H01M 2/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 수명 상태(state-of-health), 추정(estimating), 전압 균등화 정도 (state of balance by voltage)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2256117 B1 (MINTECH CO., LTD.) 26 May 2021 (2021-05-26)<br>See claims 1 and 5. | 1,4-5 |
| A | | 2-3,6 |
| Y | KR 10-2013-0142884 A (HITACHI, LTD.) 30 December 2013 (2013-12-30)<br>See claims 1-2. | 1,4-5 |
| A | JP 2001-223033 A (HITACHI LTD.) 17 August 2001 (2001-08-17)<br>See claims 1-5. | 1-6 |
| A | JP 6172176 B2 (TOYOTA MOTOR CORP.) 02 August 2017 (2017-08-02)<br>See paragraphs [0010]-[0083]. | 1-6 |
| A | JP 2019-020392 A (GS YUASA CORP.) 07 February 2019 (2019-02-07)<br>See paragraphs [0015]-[0098]. | 1-6 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 March 2023** | **10 March 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2022/019484**

| Patent document cited in search report | | | Publication date (day/month/year) | Patent family member(s) | | | Publication date (day/month/year) |
|---|---|---|---|---|---|---|---|
| KR | 10-2256117 | B1 | 26 May 2021 | CN | 113678009 | A | 19 November 2021 |
| | | | | EP | 3916411 | A1 | 01 December 2021 |
| | | | | EP | 3916411 | A4 | 20 April 2022 |
| | | | | JP | 2022-522733 | A | 20 April 2022 |
| | | | | KR | 10-2021-0067227 | A | 08 June 2021 |
| | | | | KR | 10-2281384 | B1 | 26 July 2021 |
| | | | | US | 2022-0146585 | A1 | 12 May 2022 |
| | | | | WO | 2021-107220 | A1 | 03 June 2021 |
| KR | 10-2013-0142884 | A | 30 December 2013 | CN | 103513183 | A | 15 January 2014 |
| | | | | JP | 2014-002055 | A | 09 January 2014 |
| | | | | JP | 5662968 | B2 | 04 February 2015 |
| | | | | US | 2013-0335009 | A1 | 19 December 2013 |
| JP | 2001-223033 | A | 17 August 2001 | None | | | |
| JP | 6172176 | B2 | 02 August 2017 | JP | 2016-146728 | A | 12 August 2016 |
| | | | | US | 10012699 | B2 | 03 July 2018 |
| | | | | US | 2016-0233700 | A1 | 11 August 2016 |
| JP | 2019-020392 | A | 07 February 2019 | EP | 3657190 | A1 | 27 May 2020 |
| | | | | JP | 2019-078771 | A | 23 May 2019 |
| | | | | JP | 6477957 | B2 | 06 March 2019 |
| | | | | JP | 7111015 | B2 | 02 August 2022 |
| | | | | US | 2020-0225292 | A1 | 16 July 2020 |
| | | | | WO | 2019-017183 | A1 | 24 January 2019 |

Form PCT/ISA/210 (patent family annex) (July 2022)

**EP 4 478 069 A1**

REFERENCES CITED IN THE DESCRIPTION

**Patent documents cited in the description**

- KR 1020160058281
- KR 102256117